# FASCICULE DE BREVET EUROPEEN

(11) **EP 2 574 944 B1**
(45) Date de publication et mention de la délivrance du brevet: **05.11.2014**
(21) Numéro de dépôt: 12180652.5
(22) Date de dépôt: 16.08.2012
(51) Int. Cl.: G01R 31/317

(54) **Déclenchement d'attaques sur des composants de carte à puce**
Auslösen von Angriffen auf Chipkarten-Komponenten
Attack triggering on chip card components

(30) Priorité: 28.09.2011 FR 1158701
(43) Date de publication de la demande: 03.04.2013
(73) Titulaire: Oberthur Technologies, 92300 Levallois-Perret (FR)
(72) Inventeur: Morin, Nicolas, 92000 Nanterre (FR); Giraud, Christophe, 92000 Nanterre (FR)
(74) Mandataire: Pecher, Gilles

(56) Documents cités:
- TOSHINORI FUKUNAGA ET AL: "Practical Fault Attack on a Cryptographic LSI with ISO/IEC 18033-3 Block Ciphers", FAULT DIAGNOSIS AND TOLERANCE IN CRYPTOGRAPHY (FDTC), 2009 WORKSHOP ON, IEEE, PISCATAWAY, NJ, USA, 6 septembre 2009 (2009-09-06), pages 84-92, XP031627632, ISBN: 978-1-4244-4972-9
- POUGET V ET AL: "Dynamic Testing of an SRAM-Based FPGA by Time-Resolved Laser Fault Injection", ON-LINE TESTING SYMPOSIUM, 2008. IOLTS '08. 14TH IEEE INTERNATIONAL, IEEE, PISCATAWAY, NJ, USA, 7 juillet 2008 (2008-07-07), pages 295-301, XP031287464, ISBN: 978-0-7695-3264-6
- BAR-EL H ET AL: "The Sorcerer's Apprentice Guide to Fault Attacks", PROCEEDINGS OF THE IEEE, IEEE. NEW YORK, US, vol. 94, no. 2, 1 février 2006 (2006-02-01), pages 370-382, XP011370625, ISSN: 0018-9219, DOI: 10.1109/JPROC.2005.862424

## Description

### Arrière-plan de l'invention

L'invention se rapporte au domaine des composants sécurisés de carte à puce, ou carte à circuit intégré.

Pour sécuriser le fonctionnement d'un composant de carte à puce, par exemple un microcontrôleur, les constructeurs mettent en oeuvre des verrous sécuritaires implantés dans le code du composant.

Une attaque par injection de faute consiste à perturber le composant afin de le dérouter de son comportement normal et essayer ainsi de faire « sauter » ses verrous sécuritaires. Une telle attaque par injection de faute est par exemple réalisée en envoyant une impulsion lumineuse sur le composant de carte à puce à un instant correspondant à l'exécution d'une instruction déterminée.

TOSHINORI FUKUNAGA ET AL: "Practical Fault Attack on a Cryptographie LSI with ISO/IEC 18033-3 Block Ciphers" (FAULT DIAGNOSIS AND TOLERANCE IN CRYPTOGRAPHY (FDTC), 2009 WORKSHOP ON, IEEE, PISCATAWAY, NJ, USA, 6 septembre 2009, pages 84-92, ISBN: 978-1-4244-4972-9) décrit un procédé de déclenchement d'attaques sur un circuit cryptographique.

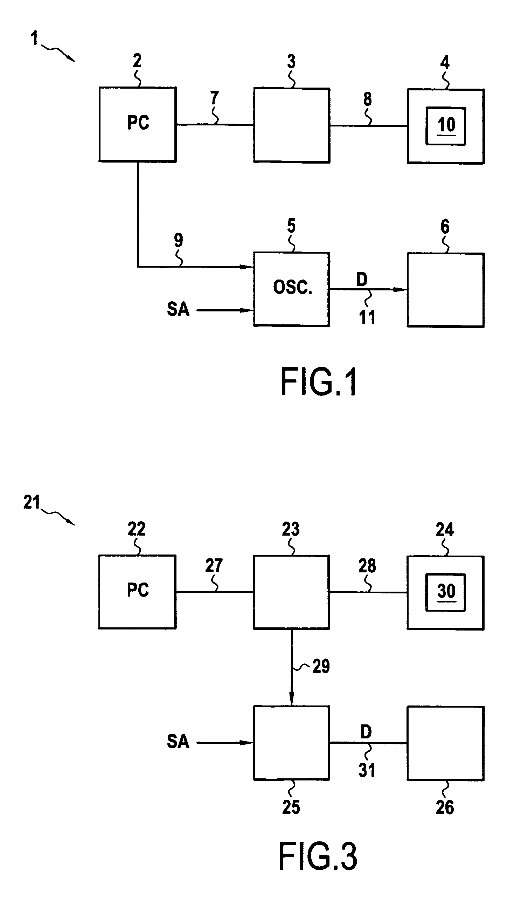

Pour tester la sécurité de ses cartes à puce face à de telles attaques, un constructeur de cartes à puce peut être amené à réaliser lui-même des attaques ou à faire réaliser des attaques par un tiers, par exemple un organisme de certification. La **figure 1** représente un système de déclenchement d'attaques pouvant être utilisé pour réaliser des attaques par un constructeur de carte à puce ou un organisme de certification.

Le système 1 de la figure 1 comprend un ordinateur 2, un lecteur 3 de carte à puce, une carte à puce 4, un oscilloscope 5 et un émetteur laser 6.

L'ordinateur 2 est relié au lecteur 3 par une liaison 7, par exemple un câble USB. L'ordinateur 2 peut envoyer des commandes vers le lecteur 3, par la liaison 7. Le lecteur 3 est capable de communiquer avec la carte à puce 4 par une liaison 8, par exemple conformément à la norme ISO7816. Lorsqu'il reçoit une commande de l'ordinateur 2, le lecteur 3 transmet la commande reçue à la carte à puce 4. La carte à puce 4 comprend des composants électroniques, notamment un microcontrôleur 10 configuré pour exécuter des instructions prédéterminées en réponse à la réception d'une commande.

L'ordinateur 2 est également relié à l'oscilloscope 5 par une liaison 9, par exemple une liaison GPIB (pour « *General Purpose Interface Bus* »), permettant à l'ordinateur d'envoyer des messages à l'oscilloscope 5, notamment un message demandant à l'oscilloscope 5 de passer d'un état désarmé à un état armé. L'oscilloscope 5 est relié à l'émetteur laser 6 par une liaison 11.

Il a été démontré que les interactions physiques d'un module électronique embarqué, par exemple un module à microcontrôleur de carte à puce, avec son environnement extérieur sont dépendantes des opérations effectuées par le module ainsi que des valeurs des variables manipulées par ces opérations. Des exemples de telles interactions sont la consommation de courant du module (signal PA), le rayonnement électromagnétique (signal EMA) ou bien le signal de radio fréquence (signal RFA) qui permet à une carte sans contact de s'alimenter et de communiquer.

Ainsi, sur la figure 1, on note SA le signal d'analyse mesuré pour analyser les opérations effectuées par le microcontrôleur 10. Le signal d'analyse SA peut être par exemple la consommation de courant, le rayonnement électromagnétique ou le signal radio fréquence de la carte à puce 4. Le signal SA est fourni à l'oscilloscope 5.

Lorsqu'il est armé, l'oscilloscope 5 est configuré pour détecter un évènement particulier sur le signal d'analyse SA et pour envoyer un signal de déclenchement D vers l'émetteur laser 6 en réponse à la détection de l'évènement particulier. L'évènement particulier est par exemple un pic d'amplitude du signal SA, correspondant à un pic de consommation de courant lors de l'exécution, par le microcontrôleur 10, d'une instruction impliquant la transmission d'une variable sur un bus.

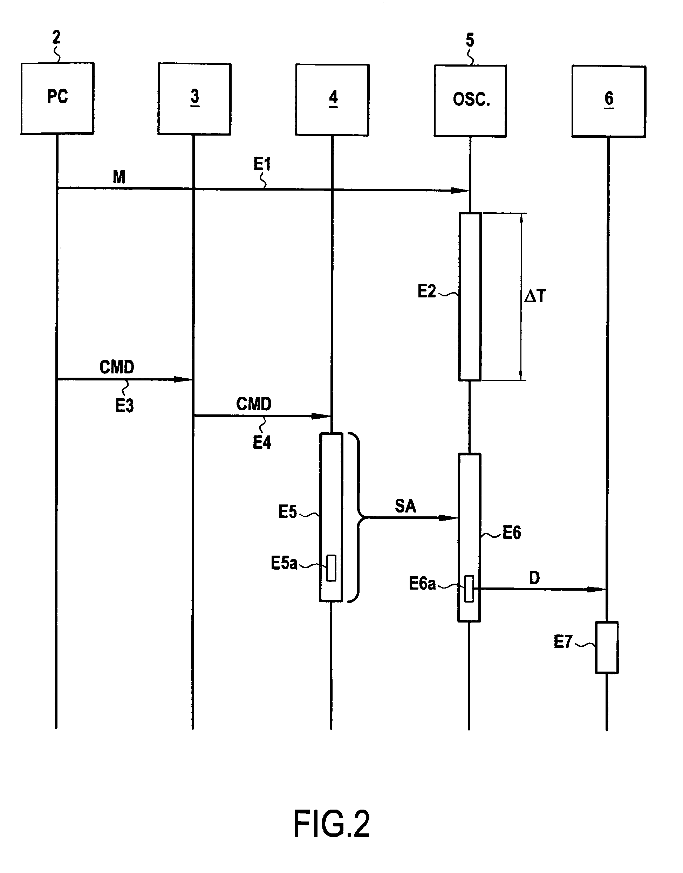

La **figure 2** représente le déclenchement d'une attaque dans le système 1 de la figure 1, en fonction du temps.

Initialement, l'oscilloscope 5 est désarmé et n'effectue aucune analyse du signal SA. Chaque commande émise par l'ordinateur 2 est transmise à la carte à puce 4 par le lecteur 3. La carte à puce 4 exécute les instructions correspondant aux commandes reçues.

Ensuite, avant l'envoi d'une commande à attaquer, l'ordinateur 2 envoie un message M d'armement à l'oscilloscope 5 (à l'étape E1). En réponse à la réception du message M, l'oscilloscope 5 s'arme (étape E2), ce qui nécessite une durée ΔT de l'ordre de 200ms. Lorsqu'il est armé, l'oscilloscope 5 analyse en permanence le signal d'analyse SA afin de détecter un évènement particulier sur le signal d'analyse SA (étape E6).

Après l'écoulement de la durée ΔT, l'ordinateur 2 envoie une commande CMD au lecteur 3 (étape E3) et le lecteur 3 transmet la commande CMD à la carte à puce 4. En réponse à la réception de la commande CMD, le microcontrôleur 10 de la carte à puce 4 exécute des instructions prédéterminées correspondant à la commande CMD (étape E5).

La commande CMD est une commande dont l'exécution comprend une instruction à attaquer. Ainsi, au cours de l'étape E5, une instruction déterminée génère l'évènement particulier sur le signal d'analyse SA (étape E5a). Cet évènement est détecté par l'oscilloscope 5 (étape E6a) qui envoie alors le signal de déclenchement D à l'émetteur laser 6.

En réponse à la réception du signal de déclenchement D, l'émetteur laser 6 envoie une impulsion lumineuse sur la carte à puce 4 (étape E7).

Le système de la figure 1 permet donc, lors de l'exécution d'instructions en réponse à la réception d'une commande, de déclencher une attaque à un instant précis correspondant à l'exécution d'une instruction prédéterminée. La commande attaquée est déterminée par l'ordinateur 2 qui arme l'oscilloscope 5 avant l'envoi de la commande en envoyant le message M d'armement.

Le système 1 de la figure 1 présente toutefois des inconvénients. En effet, l'armement de l'oscilloscope (étape E2) nécessite un temps ΔT relativement important, typiquement de l'ordre de 200ms à comparer avec environ 30ms pour l'exécution d'une commande (étape E5). Le nombre d'attaques qu'il est possible de déclencher en un temps déterminé est donc limité. De plus, un oscilloscope 5 est un équipement couteux.

Il existe donc un besoin pour une solution permettant de déclencher des attaques de manière plus efficace et moins coûteuse.

Le système 1 de la figure 1 a été décrit pour faciliter à la compréhension de l'invention et de ses avantages. Cependant, il ne faut pas en déduire que le système 1 fait partie de l'état de la technique.

### Objet et résumé de l'invention

La présente invention propose un système de déclenchement d'attaques sur un composant de carte à puce, comprenant un dispositif informatique, un lecteur de carte à puce et un dispositif d'analyse, le lecteur étant configuré pour transmettre des commandes provenant du dispositif informatique vers une carte à puce, le dispositif d'analyse étant configuré pour passer d'un état désactivé à un état activé en réponse à la réception d'un message d'activation et, lorsqu'il est dans son état activé, pour détecter un évènement prédéterminé sur un signal d'analyse provenant d'une carte à puce et pour envoyer un signal de déclenchement en réponse à la détection dudit évènement.

Ce système est remarquable en ce que le dispositif d'analyse est un détecteur de motif configuré pour détecter ledit évènement par numérisation du signal d'analyse sur n bits, n étant supérieur ou égal à 3, et comparaison d'une portion de m échantillons du signal d'analyse numérisé, m étant supérieur ou égal à 3, avec un signal de référence.

De préférence, le lecteur est configuré pour envoyer ledit message d'activation vers ledit dispositif d'analyse en réponse à la réception d'une commande déterminée.

Corrélativement, l'invention propose un procédé de déclenchement d'attaques sur un composant de carte à puce, comprenant :
- une étape de transmission, par un lecteur de carte à puce, de commandes provenant d'un dispositif informatique vers une carte à puce,
- une étape de passage, par un dispositif d'analyse, d'un état désactivé à un état activé en réponse à la réception d'un message d'activation,
- une étape de détection, par le dispositif d'analyse dans l'état activé, d'un évènement prédéterminé sur un signal d'analyse provenant d'une carte à puce, et
- une étape d'envoi, par le dispositif d'analyse, d'un signal de déclenchement en réponse à la détection dudit l'évènement.

Ce procédé est remarquable en ce que l'étape de détection dudit évènement comprend la numérisation du signal d'analyse sur n bits, n étant supérieur ou égal à 3, et la comparaison d'une portion de m échantillons du signal d'analyse numérisé, m étant supérieur ou égal à 3, avec un signal de référence.

De préférence, ledit message d'activation est envoyé vers ledit dispositif d'analyse par ledit lecteur en réponse à la réception d'une commande déterminée.

Le système et le procédé de l'invention permettent donc, lors de l'exécution d'instructions en réponse à la réception d'une commande, de déclencher une attaque à un instant précis correspondant à l'exécution d'une instruction prédéterminée. La commande attaquée est déterminée par l'instant d'activation du dispositif d'analyse. Le temps nécessaire à la transmission du message d'activation est très faible. De même, le temps nécessaire à l'activation du dispositif d'analyse est très faible en comparaison avec les longues procédures nécessaires à l'armement d'un oscilloscope. Ainsi, le temps nécessaire au déclenchement d'une attaque est plus faible que dans le cas de la figure 1. Il est donc possible d'effectuer un plus grand nombre d'attaques dans un temps déterminé.

Si le dispositif d'analyse est activé trop tôt avant l'exécution de la commande à attaquer, il est possible qu'il détecte l'évènement particulier sur le signal d'analyse sans que cet évènement ne corresponde à l'instruction à attaquer. L'envoi du message d'activation par le lecteur de carte lors de la transmission de la commande à attaquer permet de minimiser le décalage entre le début de l'exécution des instructions par la carte à puce et le début de l'analyse effectuée par le dispositif d'analyse. En effet, le lecteur est l'élément situé au plus proche de la carte à puce et du dispositif d'analyse. On minimise ainsi le risque de fausse détection.

Le lecteur peut être configuré pour mémoriser une information désignant une commande en réponse à un message provenant du dispositif informatique, et pour envoyer ledit message d'activation vers ledit dispositif d'analyse en réponse à la réception de la commande désignée par l'information mémorisée.

La commande à attaquer peut alors facilement être désignée par le dispositif informatique en envoyant le message vers le lecteur.

Dans un mode de réalisation, ladite information est une variable pouvant prendre une valeur activée et une valeur désactivée, le lecteur étant configuré pour activer ladite variable en réponse à la réception du message provenant du dispositif informatique et pour envoyer ledit message d'activation vers ledit dispositif d'analyse en réponse à la réception d'une commande lorsque la variable est activée.

La transmission du message du dispositif informatique vers le lecteur et le changement de la valeur de la variable ne nécessite qu'un temps très faible. De plus, la mémorisation de la variable ne nécessite pas beaucoup de ressources dans le lecteur.

Avantageusement, le dispositif d'analyse comprend un convertisseur analogique/numérique apte à numériser le signal d'analyse, une mémoire tampon configurée pour mémoriser une portion du signal d'analyse numérisé, une autre mémoire mémorisant un motif de référence et une unité de comparaison configurée pour comparer la portion du signal d'analyse mémorisée par la mémoire tampon avec ledit motif de référence.

L'unité de comparaison peut être configurée pour déterminer un degré de ressemblance entre la portion du signal d'analyse mémorisée par la mémoire tampon et ledit motif de référence en utilisant un algorithme d'inter-corrélation. Dans ce cas, le dispositif d'analyse peut comprendre en outre une unité de transformation configurée pour effectuer une transformation de Fourrier du signal d'analyse numérisé.

La mémoire tampon, ladite autre mémoire et l'unité de comparaison peuvent être incluses dans un circuit logique programmable ou dans un processeur de signaux numérique.

Le temps nécessaire à l'activation d'un tel détecteur de motif est très faible, en comparaison avec l'armement d'un oscilloscope.

Le système peut comprendre en outre un émetteur apte à envoyer une impulsion lumineuse vers une carte à puce reliée au lecteur en réponse à la réception du signal de déclenchement.

L'invention propose également un lecteur de carte à puce configuré pour transmettre des commandes provenant d'un dispositif informatique vers une carte à puce, **caractérisé en ce qu'**il est configuré pour envoyer un message d'activation vers un dispositif d'analyse en réponse à la réception d'une commande déterminée.

L'invention proposée également un dispositif d'analyse configuré pour passer d'un état désactivé à un état activé en réponse à la réception d'un message d'activation et, lorsqu'il est dans son état activé, pour détecter un évènement prédéterminé sur un signal d'analyse provenant d'une carte à puce et pour envoyer un signal de déclenchement en réponse à la détection dudit l'évènement, **caractérisé en ce qu'**il est configuré pour détecter ledit évènement par numérisation du signal d'analyse et comparaison d'une portion du signal d'analyse numérisé avec un signal de référence.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
- la figure 1 est un schéma qui représente un système de déclenchement d'attaques,
- la figure 2 représente le déclenchement d'une attaque dans le système de la figure 1, en fonction du temps,
- la figure 3 est un schéma qui représente un système de déclenchement d'attaques conforme à l'invention,
- la figure 4 représente le déclenchement d'une attaque dans le système de la figure 3, en fonction du temps,
- la figure 5 est un schéma qui représente le dispositif d'analyse du système de la figure 3 de manière plus détaillée, et
- la figure 6 est un graphe qui illustre le fonctionnement du dispositif d'analyse de la figure 5.

### Description détaillée d'un mode de réalisation

La **figure 3** représente un système 21 de déclenchement d'attaques pouvant être utilisé, par exemple par un constructeur de carte à puce ou un organisme de certification, pour réaliser des attaques. Le système 21 de la figure 3 comprend un ordinateur 22, un lecteur 23 de carte à puce, une carte à puce 24, un dispositif d'analyse 25 et un émetteur laser 26.

L'ordinateur 22 est relié au lecteur 23 par une liaison 27, par exemple un câble USB. L'ordinateur 22 peut envoyer des commandes vers le lecteur 33 par la liaison 27. Le lecteur 23 est capable de communiquer avec la carte à puce 24 par une liaison 28, par exemple conformément à la norme IS07816. Lorsqu'il reçoit une commande de l'ordinateur 22, le lecteur 23 transmet la commande reçue à la carte à puce 24.

La carte à puce 24 comprend des composants électroniques, notamment un microcontrôleur 30 configuré pour exécuter des instructions prédéterminées en réponse à la réception d'une commande.

Le lecteur 23 est également relié au dispositif d'analyse 25 par une liaison 29, par exemple une liaison GPIB (pour « *General Purpose Interface Bus* »), permettant au lecteur 23 d'envoyer des messages au dispositif d'analyse 25, notamment un message demandant au dispositif d'analyse 25 de passer d'un état inactif à un état actif. Le dispositif d'analyse 25 est également relié à l'émetteur laser 26 par une liaison 31.

Un signal d'analyse SA est mesuré pour analyser les opérations effectuées par le microcontrôleur 30. Le signal d'analyse SA peut être par exemple la consommation de courant, le rayonnement électromagnétique ou le signal radio fréquence de la carte à puce 24. Le signal SA est fourni au dispositif d'analyse 25.

Lorsqu'il est dans son état actif, le dispositif d'analyse 25 est configuré pour détecter un évènement particulier sur le signal d'analyse SA et pour envoyer un signal de déclenchement D vers l'émetteur laser 26 en réponse à la détection de l'évènement particulier. L'évènement particulier est par exemple un pic d'amplitude du signal SA, correspondant à un pic de consommation de courant lors de l'exécution, par le microcontrôleur 30, d'une instruction impliquant la transmission d'une variable sur un bus.

A cet effet, le dispositif d'analyse 25 effectue une numérisation du signal d'analyse SA et une comparaison à la volée du signal d'analyse numérisé avec un signal de référence. Un exemple de réalisation du dispositif d'analyse 25 sera décrit ultérieurement.

Le lecteur 23 de carte à puce mémorise une variable, appelée ci-après « Enable_trigger », qui peut prendre les valeurs 0 et 1. Initialement, Enable_trigger vaut 0. Le lecteur 23 surveille en permanence la réception de messages provenant de l'ordinateur 22 par la liaison 27 et traite les messages reçus de la manière suivante :
- Lorsque le message reçu est un message d'activation M1, le lecteur 23 change la valeur de la variable Enable_trigger à 1.
- Lorsque le message reçu est une commande et que Enable_trigger vaut 0, le lecteur 23 transmet la commande reçue vers la carte à puce 24.
- Lorsque le message reçu est une commande et que Enable_trigger vaut 1, le lecteur 23 transmet la commande reçue vers la carte à puce 24, transmet un message d'activation M2 vers le dispositif d'analyse 25 et change la valeur de Enable_trigger à 0.

Le lecteur 23 comprend par exemple un microcontrôleur programmé pour mettre en oeuvre le fonctionnement qui vient d'être décrit.

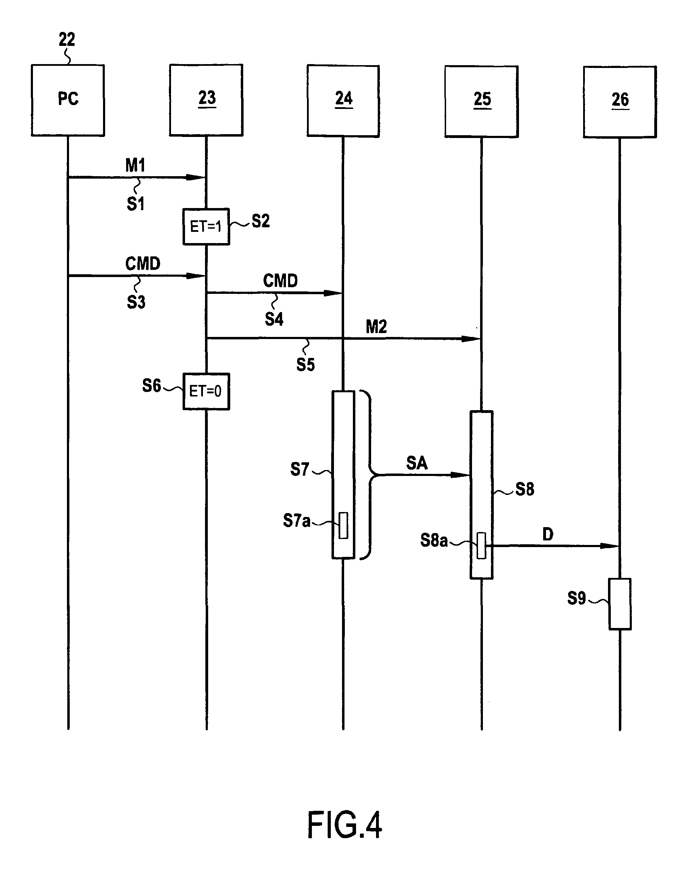

La **figure 4** représente le déclenchement d'une attaque dans le système 21 de la figure 3, en fonction du temps.

Initialement, le dispositif d'analyse 25 est inactif et n'effectue aucune analyse du signal SA. La variable Enable_trigger du lecteur 23 vaut 0. Chaque commande émise par l'ordinateur 22 est transmise à la carte à puce 24 par le lecteur 23. La carte à puce 24 exécute les instructions correspondant aux commandes reçues.

Ensuite, avant l'envoi d'une commande à attaquer, l'ordinateur 22 envoie un message d'activation M1 au lecteur 23 (étape S1). En réponse à la réception du message M1, le lecteur 23 change la valeur de la variable Enable_trigger à 1 (étape S2). Enable_trigger est noté ET sur la figure 4 par soucis de clarté.

Ensuite, l'ordinateur 22 envoie une commande CMD au lecteur 23 (étape S3). En réponse à la réception de la commande CMD, le lecteur 23 transmet la commande CMD à la carte à puce 24 (étape S4). De plus, comme Enable_trigger vaut 1, le lecteur 23 envoie un message d'activation M2 au dispositif d'analyse (étape S5) et change la valeur de la variable Enable_trigger à 0 (étape S6). Sur la figure 4, les étapes S4, S5 et S6 sont représentées l'une après l'autre, dans cet ordre. Elles peuvent toutefois être exécutées dans un ordre différent ou en parallèle.

En réponse à la réception du message d'activation M2, le dispositif d'analyse 25 passe dans son état actif. Dans cet état actif, le dispositif d'analyse 25 analyse en permanence le signal d'analyse SA afin de détecter un évènement particulier sur le signal d'analyse SA (étape S8).

Parallèlement, en réponse à la réception de la commande CMD, le microcontrôleur 30 de la carte à puce 24 exécute des instructions prédéterminées correspondant à la commande CMD (étape S7).

La commande CMD est une commande dont l'exécution comprend une instruction à attaquer. Ainsi, au cours de l'étape S7, une instruction déterminée génère l'évènement particulier sur le signal d'analyse SA (étape S7a). Cet évènement est détecté par le dispositif d'analyse (étape S8a) qui envoie alors le signal de déclenchement D à l'émetteur laser 26.

En réponse à la réception du signal de déclenchement D, l'émetteur laser 26 envoie une impulsion lumineuse sur la carte à puce 24 (étape S9).

Le système 21 de la figure 3 permet donc, lors de l'exécution d'instructions en réponse à la réception d'une commande, de déclencher une attaque à un instant précis correspondant à l'exécution d'une instruction prédéterminée. La commande attaquée est déterminée par l'ordinateur 22 qui active le dispositif d'analyse 25, par l'intermédiaire du lecteur 23, en envoyant le message d'activation M1 avant l'envoi de la commande CMD.

Le temps nécessaire à la transmission du message d'activation M1 (étape S1), au changement de Enable_trigger (étape S2) et à la transmission du message d'activation M2 (étape S5) est très faible, car il s'agit simplement de transmettre des messages et de changer la valeur d'une variable. De même, temps nécessaire à l'activation du dispositif d'analyse 25 est très faible en comparaison avec les longues procédures nécessaire à l'armement d'un oscilloscope. Ainsi, le temps nécessaire au déclenchement d'une attaque dans le système 23 de la figure 3 est plus faible que dans le cas de la figure 1. Il est donc possible d'effectuer un plus grand nombre d'attaques dans un temps déterminé.

Si le dispositif d'analyse 25 est activé trop tôt avant l'exécution de la commande à attaquer, il est possible qu'il détecte l'évènement particulier sur le signal d'analyse SA sans que cet évènement ne corresponde à l'instruction à attaquer. L'envoi du message d'activation M2 par le lecteur 23 lors de la transmission de la commande CMD à la carte à puce 24 permet de minimiser le décalage entre le début de l'exécution des instructions (étape S7) et le début de l'analyse effectuée par le dispositif d'analyse (étape S8). En effet, le lecteur 23 est l'élément situé au plus proche de la carte à puce 24 et du dispositif d'analyse 25. On minimise ainsi le risque de fausse détection.

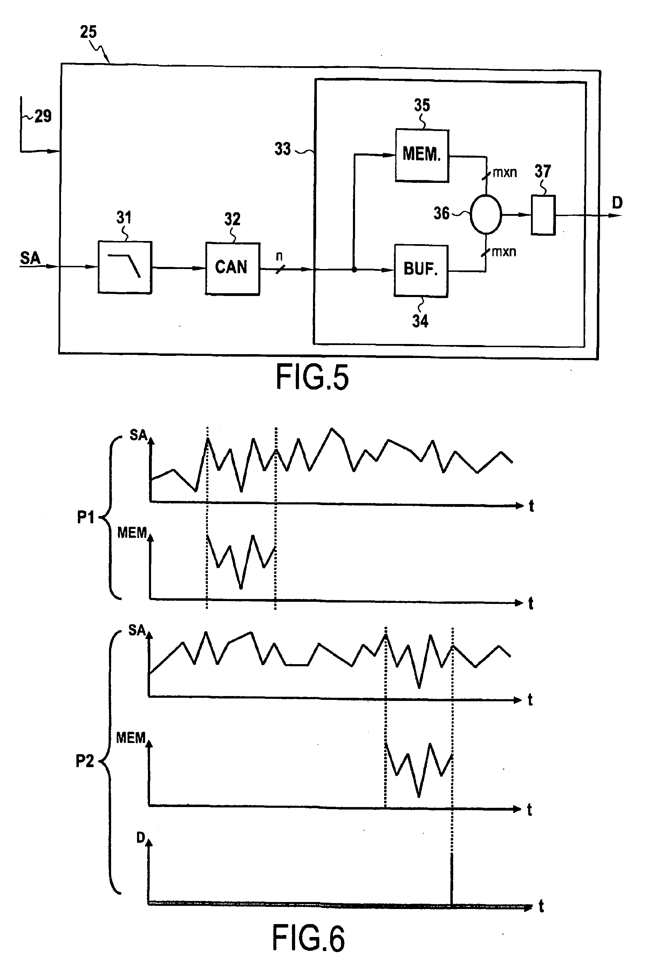

La **figure 5** représente un exemple de réalisation du dispositif d'analyse 25 de la figure 3. Le dispositif d'analyse 25 de la figure 5 est un détecteur de motif qui comprend un filtre 31, un convertisseur analogique/numérique 32 et un circuit d'analyse 33.

Le filtre 31 effectue un traitement analogique sur le signal d'analyse SA, typiquement un filtrage passe-bas. Le signal filtré est numérisé sur n bits par le convertisseur analogique/numérique 32. Le nombre de bits n est supérieur ou égale à 3, ce qui permet de détecter des motifs variés, par opposition à une simple détection binaire.

Le circuit d'analyse 33comprend une mémoire tampon 34, une autre mémoire 35 et une unité de comparaison.

Dans le mode de réalisation représenté, l'unité de comparaison est composée d'une unité d'inter-corrélation 36 effectuant un algorithme d'inter-corrélation et d'un détecteur de seuil 37 permettant de mesurer la ressemblance entre 2 courbes.

La mémoire tampon 34 mémorise à la volée m échantillons de n bits provenant du convertisseur analogique/numérique 32, sur le principe du « premier arrivé, premier sorti ». Ainsi, le contenu de la mémoire tampon 34 représente, sous la forme de m échantillons de n bits, la partie la plus récente du signal d'analyse SA. Le nombre m d'échantillons est supérieur ou égal à 3, ce qui permet de comparer la forme de courbes sur une certaine durée.

La mémoire 35 mémorise un motif de m valeurs de n bits, correspondant à l'évènement qui doit être détecté sur le signal d'analyse SA.

L'unité d'inter-corrélation 36 détermine un degré de ressemblance entre la courbe mémorisée dans la mémoire tampon 34 et la courbe mémorisée dans l'autre mémoire 35 en utilisant un algorithme d'inter-corrélation. Ensuite, le degré de ressemblance est comparé avec un seuil S prédéterminé dans l'unité de détection de seuil 37. Si le degré de ressemblance est inférieur au seuil S, on considère que le signal d'analyse SA est différent du motif mémorisé dans la mémoire 35 et le signal de déclenchement D n'est pas émis. Par contre, si le degré de ressemblance est supérieur au seuil S, on considère que le signal d'analyse SA correspond au motif mémorisé dans la mémoire 35 et le signal de déclenchement D est émis.

Dans cette variante, le circuit d'analyse 33 comprend de préférence une unité de transformation non représentée située entre la sortie du convertisseur analogique/numérique 32 et l'entrée des mémoires 34 et 35. L'unité de transformation réalise une transformation de Fourrier de type FFT. Sachant qu'il est plus facile de mettre en oeuvre un algorithme d'inter-corrélation dans le domaine fréquentiel que le domaine temporel, cela facilite le travail de l'unité de comparaison.

Le fonctionnement du circuit d'analyse 33 est activé en réponse à la réception du message d'activation M2 sur la liaison 29, et désactivé après l'émission du signal de déclenchement D.

Le circuit d'analyse 33 est réalisé par exemple par un circuit logique programmable de type FPGA. En variante, il s'agit d'un processeur numérique de signaux (DSP) configuré pour mettre en oeuvre les fonctions de la mémoire tampon 34, de l'autre mémoire 35 et de l'unité de comparaison.

La **figure 6** illustre le fonctionnement du dispositif d'analyse 25 de la figure 5.

Pendant une phase P1, le signal d'analyse SA est numérisé et une portion du signal SA est mémorisée dans la mémoire 35. Cette portion représente le motif à reconnaître.

Ensuite, pendant une phase P2, le signal d'analyse SA est numérisé et comparé à la volée au motif mémorisé. Lorsque le motif est détecté, le signal de déclenchement D est reconnu.

Dans le mode de réalisation décrit, la commande à attaquer est déterminée par l'ordinateur 22 qui envoie le message d'activation M1 juste avant la commande à attaquer. Le lecteur 23 utilise la variable Enable_trigger pour mémoriser que la prochaine commande est la commande à attaquer. Toutefois, en variante, la commande à attaquer peut être désignée d'une autre manière. Par exemple, l'ordinateur 22 peut envoyer un message contenant l'identifiant d'une commande à attaquer et le lecteur 23 mémorise cet identifiant. Cela permet d'envoyer des commandes intermédiaires entre le message et la commande à attaquer.

L'ordinateur 22 est par exemple un ordinateur personnel. En variante, il peut s'agir de tout type de dispositif informatique capable d'envoyer des commandes et un message d'activation vers un lecteur de carte.

## Revendications

1. Système (21) de déclenchement d'attaques sur un composant (30) de carte à puce (24), comprenant un dispositif informatique (22), un lecteur (23) de carte à puce et un dispositif d'analyse (25), le lecteur (23) étant configuré pour transmettre des commandes provenant du dispositif informatique (22) vers une carte à puce (24),
le dispositif d'analyse (25) étant configuré pour passer d'un état désactivé à un état activé en réponse à la réception d'un message d'activation (M2) et, lorsqu'il est dans son état activé, pour détecter un évènement prédéterminé sur un signal d'analyse (SA) provenant d'une carte à puce (24) et pour envoyer un signal de déclenchement (D) en réponse à la détection dudit évènement,
**caractérisé en ce que** le dispositif d'analyse (25) est un détecteur de motif configuré pour détecter ledit évènement par numérisation du signal d'analyse (SA) sur n bits, n étant supérieur ou égal à 3, et comparaison d'une portion de m échantillons du signal d'analyse numérisé, m étant supérieur ou égal à 3, avec un signal de référence.

2. Système (21) de déclenchement selon la revendication 1, dans lequel le lecteur (23) est configuré pour envoyer ledit message d'activation (M2) vers ledit dispositif d'analyse (25) en réponse à la réception d'une commande (CMD) déterminée.

3. Système (21) de déclenchement d'attaques selon la revendication 2, dans lequel le lecteur (23) est configuré pour mémoriser une information désignant une commande en réponse à un message (M1) provenant du dispositif informatique (22), et pour envoyer ledit message d'activation (M2) vers ledit dispositif d'analyse (25) en réponse à la réception de la commande (CMD) désignée par l'information mémorisée.

4. Système (21) de déclenchement d'attaques selon la revendication 3, dans lequel ladite information est une variable (ET) pouvant prendre une valeur activée et une valeur désactivée, le lecteur (23) étant configuré pour activer ladite variable en réponse à la réception du message (M1) provenant du dispositif informatique (22) et pour envoyer ledit message d'activation (M2) vers ledit dispositif d'analyse (25) en réponse à la réception d'une commande (CMD) lorsque la variable (ET) est activée.

5. Système (21) de déclenchement d'attaques selon l'une des revendications 1 à 4, dans lequel le dispositif d'analyse (25) comprend un convertisseur analogique/numérique (32) apte à numériser le signal d'analyse (SA) sur n bits, une mémoire tampon (34) configurée pour mémoriser une portion de m échantillons du signal d'analyse numérisé, une autre mémoire (35) mémorisant un motif de référence et une unité de comparaison (36, 37) configurée pour comparer la portion du signal d'analyse mémorisée par la mémoire tampon (34) avec ledit motif de référence.

6. Système (21) de déclenchement d'attaques selon la revendication 5, dans lequel l'unité de comparaison est configurée pour déterminer un degré de ressemblance entre la portion du signal d'analyse mémorisée par la mémoire tampon (34) et ledit motif de référence en utilisant un algorithme d'inter-corrélation.

7. Système (21) de déclenchement d'attaques selon la revendication 6, dans lequel le dispositif d'analyse comprend en outre une unité de transformation configurée pour effectuer une transformation de Fourrier du signal d'analyse numérisé.

8. Système (21) de déclenchement d'attaques selon l'une des revendications 5 à 7, dans lequel la mémoire tampon (34), ladite autre mémoire (35) et l'unité de comparaison (36, 37) sont incluses dans un circuit logique programmable (33).

9. Système (21) de déclenchement d'attaques selon l'une des revendications 5 à 7, dans lequel la mémoire tampon (34), ladite autre mémoire (35) et l'unité de comparaison (36, 37) sont incluses dans un processeur de signaux numérique.

10. Système (21) de déclenchement d'attaques selon l'une des revendications 1 à 9, comprenant en outre un émetteur (26) apte à envoyer une impulsion lumineuse vers une carte à puce (24) reliée au lecteur (23) en réponse à la réception du signal de déclenchement (D).

11. Procédé de déclenchement d'attaques sur un composant (30) de carte à puce (24), comprenant :
- une étape de transmission, par un lecteur (23) de carte à puce, de commandes provenant d'un dispositif informatique (22) vers une carte à puce (24),
- une étape de passage, par un dispositif d'analyse (25), d'un état désactivé à un état activé en réponse à la réception d'un message d'activation (M2),
- une étape (S8a) de détection, par le dispositif d'analyse (25) dans l'état activé, d'un évènement prédéterminé sur un signal d'analyse (SA) provenant d'une carte à puce (24), et
- une étape d'envoi, par le dispositif d'analyse (25), d'un signal de déclenchement (D) en réponse à la détection dudit l'évènement,
**caractérisé en ce que** l'étape de détection dudit évènement comprend la numérisation du signal d'analyse sur n bits, n étant supérieur ou égal à 3, et la comparaison d'une portion de m échantillons du signal d'analyse numérisé, m étant supérieur ou égal à 3, avec un signal de référence.

## Patentansprüche

1. System (21) zur Auslösung von Angriffen auf eine Komponente (30) einer Chipkarte (24), umfassend eine Computervorrichtung (22), einen Chipkartenleser (23) und eine Analysevorrichtung (25), wobei der Leser (23) dazu ausgelegt ist, von der Computervorrichtung (22) kommende Befehle an eine Chipkarte (24) zu übertragen,
wobei die Analysevorrichtung (25) dazu ausgelegt ist, als Reaktion auf den Empfang einer Aktivierungsnachricht (M2) von einem deaktivierten Zustand in einen aktivierten Zustand überzugehen und, wenn sie sich in ihrem aktivierten Zustand befindet, ein vorbestimmtes Ereignis auf einem von einer Chipkarte (24) kommenden Analysesignal (SA) zu erfassen und als Reaktion auf die Erfassung des Ereignisses ein Auslösesignal (D) zu senden,
**dadurch gekennzeichnet, dass** die Analysevorrichtung (25) ein Musterdetektor ist, der dazu ausgelegt ist, das Ereignis durch Digitalisierung des Analysesignals (SA) in n Bits, wobei n größer oder gleich 3 ist, und Vergleichen eines Teils von m Samples des digitalisierten Analysesignals, wobei m größer oder gleich 3 ist, mit einem Referenzsignal zu erfassen.

2. Auslösesystem (21) nach Anspruch 1, bei dem der Leser (23) dazu ausgelegt ist, die Aktivierungsnachricht (M2) als Reaktion auf den Empfang eines bestimmten Befehls (CMD) an die Analysevorrichtung (25) zu senden.

3. System (21) zur Auslösung von Angriffen nach Anspruch 2, bei dem der Leser (23) dazu ausgelegt ist, als Reaktion auf eine von der Computervorrichtung (22) kommende Nachricht (M1) eine einen Befehl bezeichnende Information zu speichern und als Reaktion auf den Empfang des durch die gespeicherte Information bezeichneten Befehls (CMD) die Aktivierungsnachricht (M2) an die Analysevorrichtung (25) zu senden.

4. System (21) zur Auslösung von Angriffen nach Anspruch 3, bei dem die Information eine Variable (ET) ist, die einen aktivierten Wert und einen deaktivierten Wert annehmen kann, wobei der Leser (23) dazu ausgelegt ist, als Reaktion auf den Empfang der von der Computervorrichtung (22) kommenden Nachricht (M1) die Variable zu aktivieren und als Reaktion auf den Empfang eines Befehls (CMD), wenn die Variable (ET) aktiviert ist, die Aktivierungsnachricht (M2) an die Analysevorrichtung (25) zu senden.

5. System (21) zur Auslösung von Angriffen nach einem der Ansprüche 1 bis 4, bei dem die Analysevorrichtung (25) einen Analog/Digital-Wandler (32), welcher geeignet ist, das Analysesignal (SA) in n Bits zu digitalisieren, einen Pufferspeicher (34), welcher dazu ausgelegt ist, einen Teil von m Samples des digitalisierten Analysesignals zu speichern, einen weiteren Speicher (35), welcher ein Referenzmuster speichert, sowie eine Vergleichseinheit (36, 37), welche dazu ausgelegt ist, den durch den Pufferspeicher (34) gespeicherten Teil des Analysesignals mit dem Referenzmuster zu vergleichen, umfasst.

6. System (21) zur Auslösung von Angriffen nach Anspruch 5, bei dem die Vergleichseinheit dazu ausgelegt ist, unter Verwendung eines Kreuzkorrelationsalgorithmus einen Ähnlichkeitsgrad zwischen dem durch den Pufferspeicher (34) gespeicherten Teil des Analysesignals und dem Referenzmuster zu bestimmen.

7. System (21) zur Auslösung von Angriffen nach Anspruch 6, bei dem die Analysevorrichtung ferner eine Transformationseinheit umfasst, die dazu ausgelegt ist, eine Fourier-Transformation des digitalisierten Analysesignals zu vollziehen.

8. System (21) zur Auslösung von Angriffen nach einem der Ansprüche 5 bis 7, bei dem der Pufferspeicher (34), der weitere Speicher (35) und die Vergleichseinheit (36, 37) in eine programmierbare logische Schaltung (33) eingeschlossen sind.

9. System (21) zur Auslösung von Angriffen nach einem der Ansprüche 5 bis 7, bei dem der Pufferspeicher (34), der weitere Speicher (35) und die Vergleichseinheit (36, 37) in eine digitalen Signalprozessor eingeschlossen sind.

10. System (21) zur Auslösung von Angriffen nach einem der Ansprüche 1 bis 9, ferner umfassend einen Sender (26), der geeignet ist, als Reaktion auf den Empfang des Auslösesignals (D) einen Lichtimpuls an eine mit dem Leser (23) verbundene Chipkarte (24) zu senden.

11. Verfahren zur Auslösung von Angriffen auf eine Komponente (30) einer Chipkarte (24), umfassend:
- einen Schritt zur Übertragung von von einer Computervorrichtung (22) kommenden Befehlen durch einen Chipkartenleser (23) an eine Chipkarte (24),
- einen Schritt zum Übergang, durch eine Analysevorrichtung (25), von einem deaktivierten Zustand in einen aktivierten Zustand als Reaktion auf den Empfang einer Aktivierungsnachricht (M2),
- einen Schritt (S8a) zur Erfassung, durch die Analysevorrichtung (25) in dem aktivierten Zustand, eines vorbestimmten Ereignisses auf einem von einer Chipkarte (24) kommenden Analysesignal (SA), und
- einen Schritt zum Senden, durch die Analysevorrichtung (25), eines Auslösesignals (D) als Reaktion auf die Erfassung des Ereignisses,
**dadurch gekennzeichnet, dass** der Schritt der Erfassung des Ereignisses die Digitalisierung des Analysesignals in n Bits, wobei n größer oder gleich 3 ist, und das Vergleichen eines Teils von m Samples des digitalisierten Analysesignals, wobei m größer oder gleich 3 ist, mit einem Referenzsignal umfasst.

## Claims

1. A system (21) for triggering attacks on a chip card (24) component (30), comprising a computer device (22), a chip card reader (23) and an analysis device (25), the reader (23) being configured to send commands from the computer device (22) to a chip card (24),
the analysis device (25) being configured to go from a deactivated state to an activated state in response to the receipt of an activation message (M2) and, when it is in its activated state, to detect a predetermined event on an analysis signal (SA) coming from a chip card (24) and to send a triggering signal (D) in response to the detection of said event,
**characterized in that** the analysis device (25) is a pattern detector configured to detect said event by digitizing the analysis signal (SA) on n bits, n being greater than or equal to 3, and comparing a portion of m samples of the digitized analysis signal, m being greater than or equal to 3, with a reference signal.

2. The triggering system (21) according to claim 1, wherein the reader (23) is configured to send said activation message (M2) to said analysis device (25) in response to the receipt of a predetermined command (CMD).

3. The attack triggering system (21) according to claim 2, wherein the reader (23) is configured to store information designating a command in response to a message (M1) coming from the computer device (22), and to send said activation message (M2) to said analysis device (25) in response to the receipt of the command (CMD) designated by the stored information.

4. The attack triggering system (21) according to claim 3, wherein said information is a variable (ET) that can assume an activated value and a deactivated value, the reader (23) being configured to activate said variable in response to the reception of the message (M1) coming from the computer device (22) and to send said activation message (M2) to said analysis device (25) in response to the receipt of a command (CMD) when the variable (ET) is activated.

5. The attack triggering system (21) according to one of claims 1 to 4, wherein the analysis device (25) comprises an analog-digital converter (32) capable of digitizing the analysis signal (SA) on n bits, a buffer memory (34) configured to store a portion of m samples of the digitized analysis signal, another memory (35) storing a reference pattern, and a comparison unit (36, 37) configured to compare the portion of the analysis signal stored by the buffer memory (34) with said reference pattern.

6. The attack triggering system (21) according to claim 5, wherein the comparison unit is configured to determine a degree of similarity between the portion of the analysis signal stored by the buffer memory (34) and said reference pattern by using an intercorrelation algorithm.

7. The attack triggering system (21) according to claim 6, wherein the analysis device further comprises a transformation unit configured to perform a Fourier transform of the digitized analysis signal.

8. The attack triggering system (21) according to one of claims 5 to 7, wherein the buffer memory (34), said other memory (35) and the comparison unit (36, 37) are included in a programmable logic circuit (33).

9. The attack triggering system (21) according to one of claims 5 to 7, wherein the buffer memory (34), said other memory (35) and the comparison unit (36, 37) are included in a digital signal processor.

10. The attack triggering system (21) according to one of claims 1 to 9, further comprising a transmitter (26) capable of sending a light pulse to a chip card (24) connected to the reader (23) in response to the receipt of the triggering signal (D).

11. A method for triggering attacks on a chip card (24) component (30), comprising:
- a step for the transmission, by a chip card reader (23), of commands from a computer device (22) to a chip card (24),
- a step for the transition, by an analysis device (25), from a deactivated state to an activated state in response to the receipt of an activation message (M2),
- a step (S8a) for the detection, by the analysis device (25) in the activated state, of a predetermined event on an analysis signal (SA) coming from a chip card (24), and
- a step for the sending, by the analysis device (25), of a triggering signal (D) in response to the detection of said event,
**characterized in that** the step for detecting said event comprises the digitizing the analysis signal on n bits, n being greater than or equal to 3, and comparing a portion of m samples of the digitized analysis signal, m being greater than or equal to 3, with a reference signal.
